# EUROPÄISCHE PATENTANMELDUNG

(11) **EP 3 490 087 A1**
(43) Veröffentlichungstag der Anmeldung: **29.05.2019**
(21) Anmeldenummer: 17203777.2
(22) Anmeldetag: 27.11.2017
(51) Int. Cl.: H02B 1/56, H05K 7/20

(54) **SCHALTSCHRANKENTWÄRMUNG**

(71) Anmelder: Siemens Aktiengesellschaft, 80333 München (DE)
(72) Erfinder: Knauer, Hans, 91359 Leutenbach (DE)

(57) **Zusammenfassung**

Die Erfindung betrifft einen Stromrichter (1) mit einem Leistungsteil (2) und einem Schaltschrank (3), wobei der Stromrichter (1) eine Luftkühlung mittels Kühlluft aufweist. Zur Verbesserung der Kühlung eines Stromrichters wird vorgeschlagen, dass zur Kühlung des Leistungsteils (2) der Stromrichter (1) einen gegenüber dem Innern des Schaltschrankes (3) geschlossenen Kühlluftkanal (4) aufweist. Ferner betrifft die Erfindung ein Verfahren zum Kühlen eines derartigen Stromrichters (1), wobei die für die Kühlung des Leistungsteils (2) verwendete Kühlluft durch eine Öffnung (7) des Kühlluftkanals (4) an die Umgebung außerhalb des Schaltschrankes (3) abgegeben wird.

## Beschreibung

Die Erfindung betrifft einen Stromrichter mit einem Leistungsteil und einem Schaltschrank, wobei der Stromrichter eine Luftkühlung mittels Kühlluft aufweist. Ferner betrifft die Erfindung ein Verfahren zum Kühlen eines derartigen Stromrichters.

Stromrichter weisen insbesondere bei großen Leistungen einen Schaltschrank auf. Dabei wird das Leistungsteil der Stromrichter in der Regel in diesen Schaltschrank eingebaut. Der Leistungsteil des Stromrichters umfasst im Wesentlichen Kondensatoren und Halbleiter. In demselben Schaltschrank befinden zudem weitere elektrische Komponenten wie Sicherungen, Regelungseinheiten, Schalter, Drosseln, Bedienpanel, Ansteuerbaugruppen, Energieversorgungsbaugruppen, Kommunikationsbaugruppen usw.. Oftmals werden diese weiteren Komponenten auch als Hilfskomponenten bezeichnet. Manche dieser Hilfskomponenten, hauptsächlich Komponenten der Informationselektronik wie beispielsweise Regelungsbaugruppe, Bedienpanel, Kommunikationsbaugruppen, sind nur für eine niedrige Maximaltemperatur im Bereich von 60°C bis 65°C zugelassen. Dies gilt auch für Energieversorgungsbaugruppen, beispielsweise für die Ansteuerbaugruppe der Halbleiter.

Mit der Steigerung der Leistungsfähigkeit des Leistungsteils steigen auch die Verluste, die zu einer Erwärmung des Schaltschrankes führen. Um für den Schaltschrank kostengünstige Hilfskomponenten mit einer Maximaltemperatur von 60°C bis 65°C nutzen zu können, muss die Kühlung des Stromrichters entsprechend leistungsfähig sein.

Derzeit wird die für die Kühlung verwendete Luft, auch als vorerwärmte Abluft bezeichnet, des Leistungsteils nach oben in den Schaltschrank geblasen und verteilt ich im Innern des Schaltschrankes. Durch ein Zonenkonzept im Schaltschrank wird sichergestellt, dass die Elektronikkomponenten in einem für sie zulässigen Temperaturbereich angeordnet sind. Dieses Zonenkonzept wird entweder über Schottungs-Maßnahmen, Schrank-Zusatzlüfter oder einer Kombination dieser Maßnahmen realisiert. Eine weitere, jedoch seltenere und zugleich auch sehr teurere Variante zur Kühlung von Schrankkomponenten ist die Schaltschrankkühlung mittels Klimageräten. Diese findet vor allem bei hohen Schrankschutzarten Anwendung.

Der Erfindung liegt die Aufgabe zugrunde, die Kühlung eines Stromrichters zu verbessern.

Diese Aufgabe wird durch einen Stromrichter mit einem Leistungsteil und einem Schaltschrank gelöst, wobei der Stromrichter eine Luftkühlung mittels Kühlluft aufweist, wobei zur Kühlung des Leistungsteils der Stromrichter einen gegenüber dem Innern des Schaltschrankes geschlossenen Kühlluftkanal aufweist. Ferner wird diese Aufgabe durch ein Verfahren zum Kühlen eines derartigen Stromrichters gelöst wobei die für die Kühlung des Leistungsteils verwendete Kühlluft durch eine Öffnung des Kühlluftkanals außerhalb des Schaltschrankes an die Umgebung abgegeben wird.

Weitere vorteilhafte Ausgestaltungen der Erfindung sind in den abhängigen Ansprüchen angegeben.

Der Erfindung liegt die Erkenntnis zugrunde, dass sich die Kühlung des Stromrichters dadurch verbessern lässt, dass die Kühlluft zum Kühlen des Leistungsteils in einem gegenüber dem Innern des Schaltschranks geschlossenem Kühlkanal geführt wird. Damit stellt auch eine Erwärmung der zur Kühlung verwendeten Luft auf Temperaturen von ca. 70°C bis 80°C kein Problem für die Hilfskomponenten im Schaltschrank dar, da diese Luft vom Innern des Schaltschrankes, der sich außerhalb des Kühlluftkanals befindet, ferngehalten und an die Umgebung außerhalb des Schaltschrankes abgegeben wird. Gleichzeitig ist auch die Aufstellung des Schaltschrankes im Bereich höherer Umgebungstemperaturen möglich. Höhere Umgebungstemperaturen führen zu einer Erhöhung der Kühllufttemperatur, die beispielsweise auch oberhalb von 80°C liegt. Durch das Fernhalten dieser Luft vom Bereich im Innern des Schaltschrankes, der sich außerhalb des Kühlluftkanals befindet, ist der Einsatz von Hilfskomponenten mit einer zulässigen Maximaltemperatur von 60°C bis 65°C im Schaltschrank auf einfache Weise möglich.

Damit wird zuverlässig vermieden, dass die vorerwärmte Abluft des Leistungsteils zu den Hilfskomponenten im Innenraum des Schaltschrankes gelangt. Dieser Luftstrom entwärmt ca. 90% der Leistungsteilverluste (Halbleiter- und Zwischenkreiskondensator-Verluste). Die Verluste des Leistungsteils werden ohne relevante Erwärmung des Schaltschrank-Innenraums nach außen abgeführt. Damit lassen sich auf besonders einfache Weise niedrige Temperaturen im Innern des Schaltschrankes realisieren.

Darüber hinaus können in vorteilhafter Weise mehrere Stromrichter in einer Schrankreihe an einem gemeinsamen Zuluftkanal und/oder einem gemeinsamen Abluftkanal ohne aufwändige Schottungmaßnahmen im Schrank angeschlossen werden. Dies hat den Vorteil, dass der Aufwand für die Klimatisierung eines Schaltraums deutlich reduziert wird.

Bei einer weiteren vorteilhaften Ausgestaltung der Erfindung weist das Leistungsteil ein Mittel zur Luftführung auf, wobei ein Teil des gegenüber dem Innern des Schaltschrankes geschlossenen Kühlluftkanal durch das Mittel zur Luftführung des Leistungsteils gebildet wird. Dabei wird der Kühlluftkanal durch einen ersten Kanalteil zur Verbindung des Ortes des Kühllufteintritts in den Kühlluftkanal mit dem Mittel zur Luftführung des Leistungsteils, einen zweiten Kanalteil zur Verbindung des Ortes des Kühlluftaustritts aus dem Kühlluftkanal mit dem Mittel zur Luftführung des Leistungsteils und dem Mittel zur Luftführung des Leistungsteils gebildet. Diese Kanalteile werden jeweils über eine mechanische Schnittstelle am Leistungsteil miteinander verbunden. Damit diese Übergänge luftdicht sind, ist an dem Leistungsteil eine Dichtung vorhanden, die ein Austreten von Luft am Übergang zum Leistungsteil verhindert. Die Abwärme des Leistungsteils wird beispielsweise durch das Schaltschrankdach nach außen abgeführt. Die Verbindung von Leistungsteil zu den Teilen des Kühlluftkanals erfolgt beispielsweise durch das Einschieben des Leistungsteils im Schaltschrank. Die korrekte Positionierung der Kanäle zueinander wird in vorteilhafter Weise über eine schiefe Ebene sichergestellt. Toleranzen an der Schnittstelle werden über eine Dichtung am Leistungsteil ausgeglichen. Der erste und der zweite Teil des Kühlluftkanals im Schaltschrank können bereits vor dem Einbau des Leistungsteils erfolgen und müssen auch bei einem eventuellen Tausch des Leistungsteils nicht demontiert werden. Der erste Kanalteil weist in einer vorteilhaften Anordnung eine Lüfterkonsole auf. Der zweite Kanalteil stellt in vorteilhafter Weise einen Abluftkamin dar. Durch Modifikationen dieser Kühlkomponenten können auf einfache Weise unterschiedliche Luftführungen im Schranksystem realisiert werden.

Bei einer weiteren vorteilhaften Ausgestaltung der Erfindung weist der Kühlluftkanal eine Öffnung für den Austritt der Kühlluft auf, wobei die Öffnung am Dach des Schaltschrankes angeordnet ist, wobei der Schaltschrank im Bereich der Öffnung eine Ablufthaube aufweist. Die Öffnung stellt den Ort dar, an dem die vorerwärmte Kühlluft den Kühlluftkanal verlässt. Für hohe Schrank-Schutzarten kann durch den Einbau einer Ablufthaube im Bereich der Öffnung am Dach des Schaltschrankes sichergestellt werden, dass der Schaltschrankinnenraum zuverlässig vor eindringenden Staub und Wasser geschützt wird.

Im Folgenden wird die Erfindung anhand der in den Figuren dargestellten Ausführungsbeispiele näher beschrieben und erläutert. Es zeigen:
- FIG 1: einen Stromrichter,
- FIG 2: ein Leistungsteil und
- FIG 3 bis FIG 12: Luftführungskonzepte für Stromrichter.

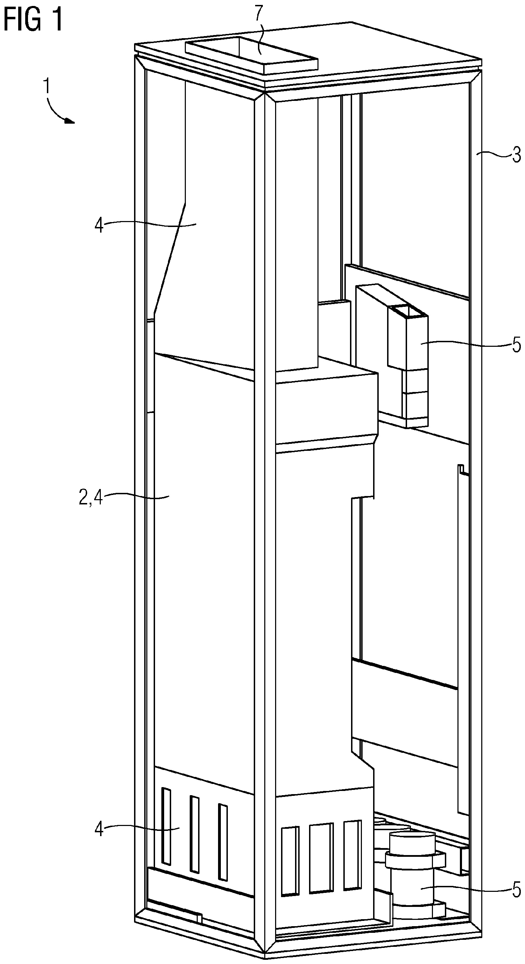

Die FIG 1 zeigt einen Stromrichter 1. Dieser weist einen Schaltschrank 3 auf. In dem Schaltschrank 3 ist ein Leistungsteil 2 angeordnet. Dieses Leistungsteil 2 bildet mit seinem hier nicht genauer dargestellten Mittel 6 zur Luftführung einen Teil des Kühlluftkanals 4. Unterhalb des Leistungsteils 2 befindet sich ein erster Teil des Kühlluftkanals 4, der in vorteilhafter Weise eine Lüfterkonsole aufweist. Oberhalb des Leistungsteils 2 bildet ein Abluftkamin einen zweiten Teil des Kühlluftkanals 4. Die Öffnung 7 des Kühlluftkanals 4, die für den Austritt der Kühlluft vorgesehen ist, ist am Dach außerhalb Schaltschrankes 3 angeordnet, so dass die Abluft vom Innern des Schaltschrankes 3 und damit von den teilweise temperaturempfindlichen Hilfskomponenten 5 ferngehalten wird. Aus diesem Grund ist der Kühlluftkanal 4 in seinem Verlauf gegenüber dem Innern des Schaltschrankes 3 geschlossen. Eine besondere Abschottung im Innern des Schaltschrankes 3 zum Schutz von Hilfskomponenten 5 vor zu warmer Luft kann dadurch vermieden werden.

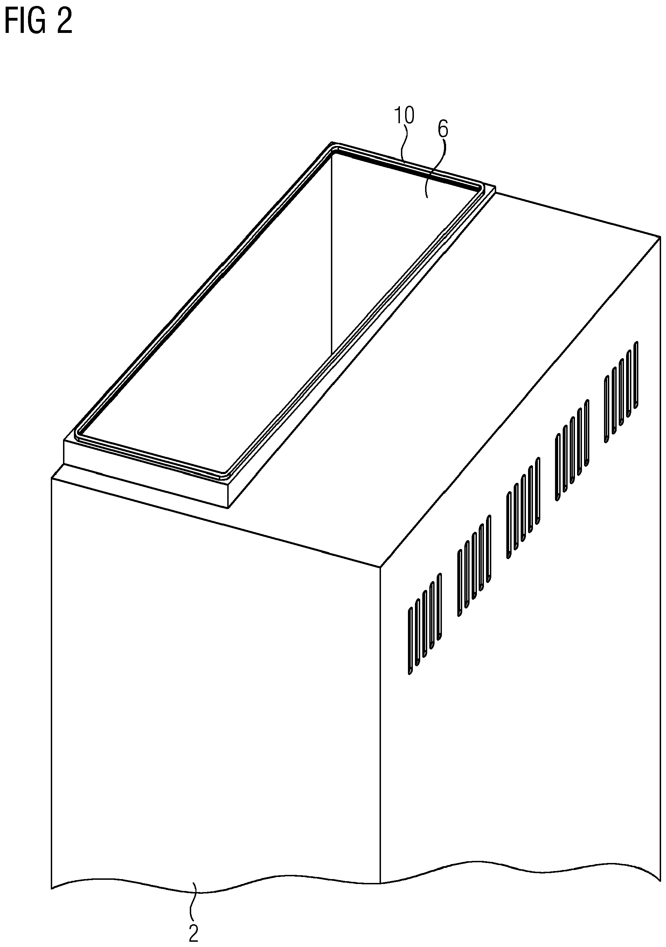

Die FIG 2 zeigt ein Leistungsteil 2. Dieses Leistungsteil 2 weist Mittel 6 zur Luftführung auf, die zusammen mit dem ersten und zweiten Teil des Kühlluftkanals 4 den Kühlluftkanal 4 bilden. Um ein Austreten von Kühlluft aus dem Kühlluftkanal am Übergang des Kühlluftkanals 4 zwischen Leistungsteil 2 und ersten bzw. zweiten Teil des Kühlluftkanals 4 zu verhindern, weist die Öffnung 7 eine umlaufende Dichtung 10 auf. Diese Dichtung 10 ist derart groß und flexibel, dass das Leistungsteil 2 auch bei bereits im Schaltschrank 3 montierten ersten und zweiten Teil des Kühlluftkanals 4 montiert bzw. demontiert werden kann. Somit kann das Leistungsteil 2 auf einfache Weise getauscht werden ohne die übrigen Teile des Kühlluftkanals 4 ausbauen zu müssen.

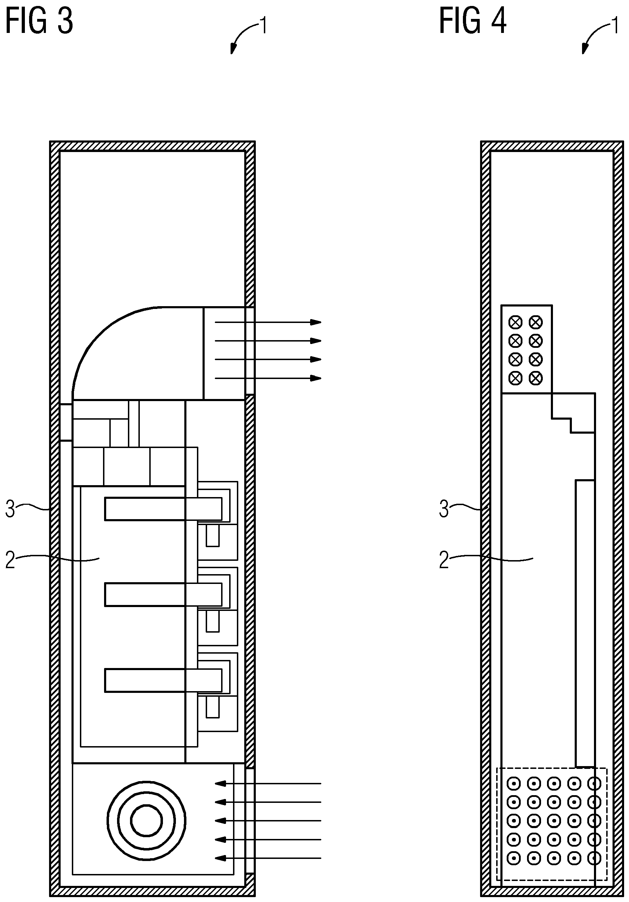

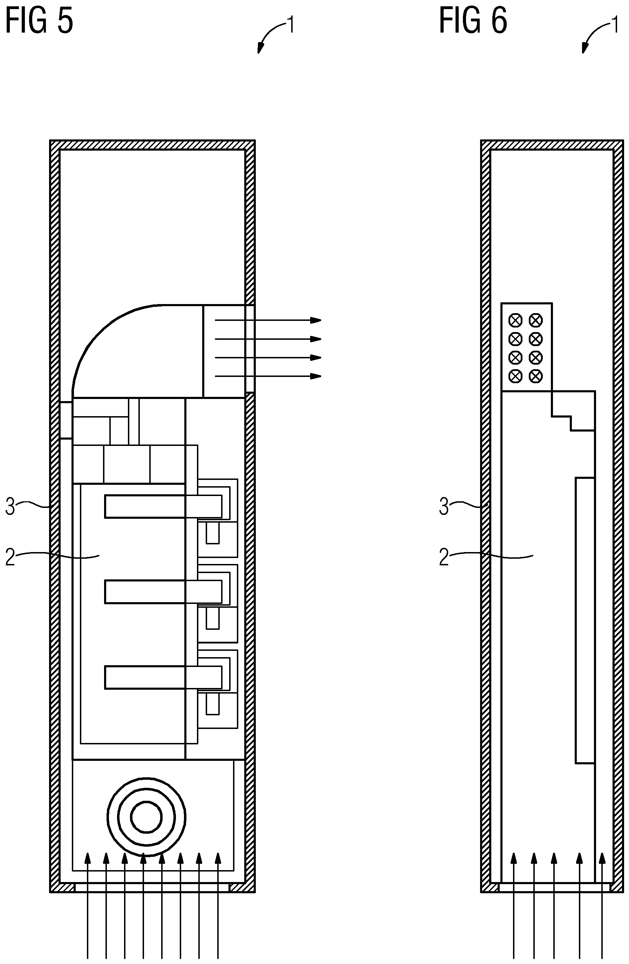

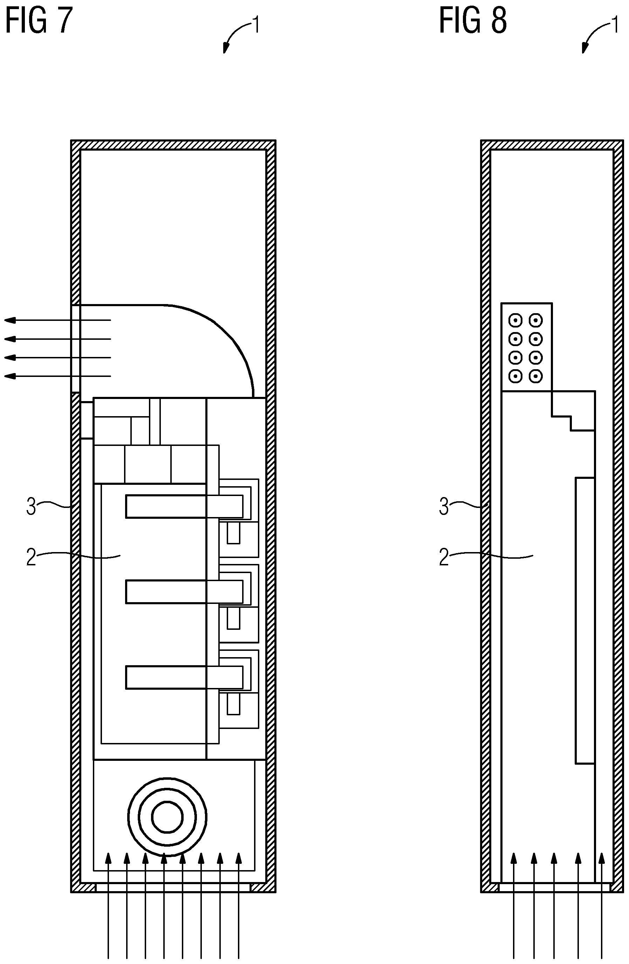

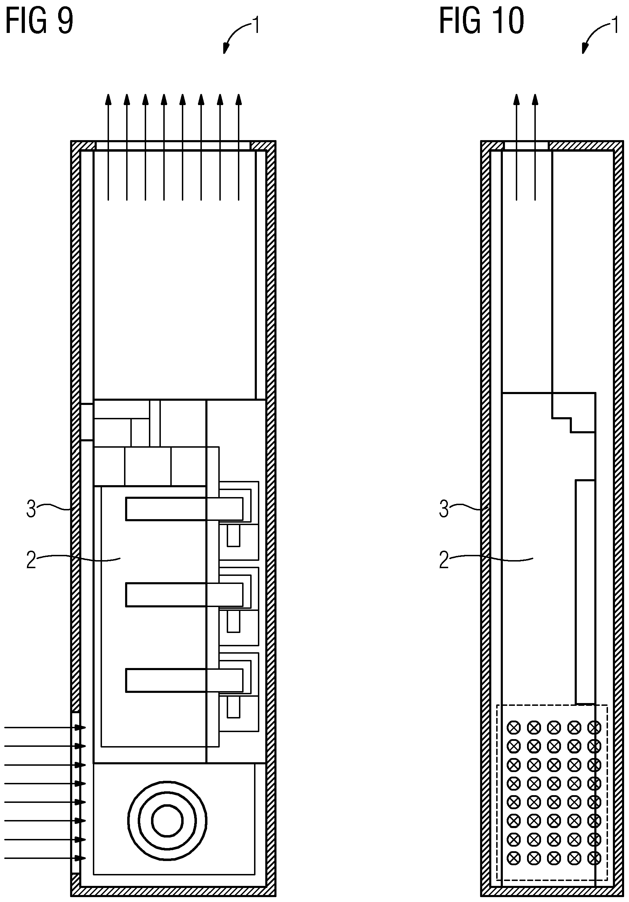

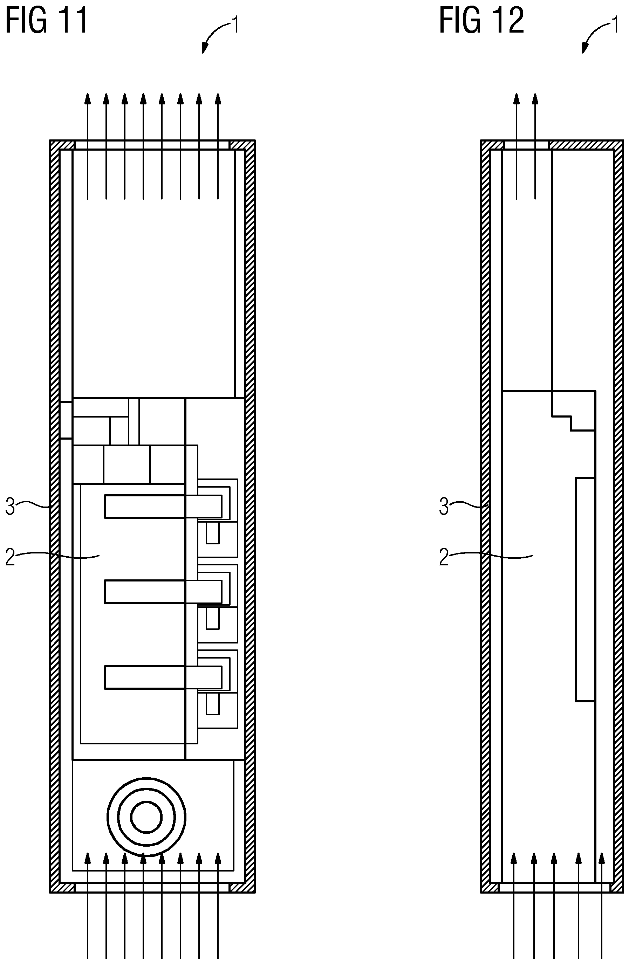

Die Figuren 3 bis 12 zeigen unterschiedliche Luftströmungskonzepte. Dabei sind die unterschiedlichen Luftführungskonzepte jeweils in zwei Figuren dargestellt. Die erste der beiden Figuren zeigt jeweils eine Seitenansicht und in der jeweiligen zweiten Figur ist eine Frontansicht dargestellt. Beim Ausführungsbeispiel der Figuren 3 und 4 wird die Kühlluft im unteren Bereich des Schaltschrankes 3 seitlich angesaugt und oberhalb des Leistungsteils 2 seitlich ausgeblasen. Beim Ausführungsbeispiel der Figuren 5 und 6 wird die Kühlluft im unteren Bereich des Schaltschrankes 3 von unten angesaugt und oberhalb des Leistungsteils 2 seitlich nach vorne ausgeblasen. Beim Ausführungsbeispiel der Figuren 7 und 8 wird die Kühlluft im unteren Bereich des Schaltschrankes 3 von unten angesaugt und oberhalb des Leistungsteils 2 seitlich nach hinten ausgeblasen. Beim Ausführungsbeispiel der Figuren 9 und 10 wird die Kühlluft im unteren Bereich des Schaltschrankes 3 seitlich angesaugt und oberhalb des Leistungsteils 2 nach oben aus dem Schaltschrank 3 ausgeblasen. Beim Ausführungsbeispiel der Figuren 11 und 12 wird die Kühlluft im unteren Bereich des Schaltschrankes 3 von unten angesaugt und oberhalb des Leistungsteils 2 nach oben aus dem Schaltschrank 3 ausgeblasen. Allen Ausführungsbeispielen der Figuren 3 bis 12 ist gemeinsam, dass im Innern des Schaltschrankes 3 die Kühlluft im Kühlluftkanal 4 geführt wird und damit von den Hilfskomponenten 5 des Stromrichters 1 isoliert ist.

Zusammenfassend betrifft die Erfindung einen Stromrichter mit einem Leistungsteil und einem Schaltschrank, wobei der Stromrichter eine Luftkühlung mittels Kühlluft aufweist. Zur Verbesserung der Kühlung eines Stromrichters wird vorgeschlagen, dass zur Kühlung des Leistungsteils der Stromrichter einen gegenüber dem Innern des Schaltschrankes geschlossenen Kühlluftkanal aufweist. Ferner betrifft die Erfindung ein Verfahren zum Kühlen eines derartigen Stromrichters, wobei die für die Kühlung des Leistungsteils verwendete Kühlluft durch eine Öffnung des Kühlluftkanals an die Umgebung außerhalb des Schaltschrankes abgegeben wird.

## Patentansprüche

1. Stromrichter (1) aufweisend
- einen Leistungsteil (2) und
- einen Schaltschrank (3),
wobei der Stromrichter (1) eine Luftkühlung mittels Kühlluft aufweist, wobei zur Kühlung des Leistungsteils (2) der Stromrichter (1) einen gegenüber dem Innern des Schaltschrankes (3) geschlossenen Kühlluftkanal (4) aufweist.

2. Stromrichter (1) nach Anspruch 1, wobei das Leistungsteil (2) ein Mittel (6) zur Luftführung aufweist, wobei ein Teil des gegenüber dem Innern des Schaltschrankes (3) geschlossenen Kühlluftkanal (4) durch das Mittel (6) zur Luftführung des Leistungsteils (2) gebildet wird.

3. Stromrichter (1) nach einem der Ansprüche 1 oder 2, wobei der Kühlluftkanal eine Öffnung (7) für den Austritt der Kühlluft aufweist, wobei die Öffnung (7) am Dach des Schaltschrankes (3) angeordnet ist, wobei der Schaltschrank (3) im Bereich der Öffnung (7) eine Ablufthaube aufweist.

4. Verfahren zum Kühlen eines Stromrichters (1) nach einem der Ansprüche 1 bis 3, wobei die für die Kühlung des Leistungsteils (2) verwendete Kühlluft durch eine Öffnung (7) des Kühlluftkanals (4) außerhalb des Schaltschrankes (3) an die Umgebung abgegeben wird.

5. Verfahren nach Anspruch 4 mit einem Stromrichter (1) gemäß Anspruch 2, wobei durch Einbringen des Leistungsteils (2) der Kühlluftkanal (4) gegenüber dem Innern des Schaltschrankes (3) geschlossenen wird.
